(19) Europäisches Patentamt
European Patent Office
Office européen des brevets

(11) **EP 4 078 208 B1**

(12) **FASCICULE DE BREVET EUROPEEN**

(45) Date de publication et mention de la délivrance du brevet:
**14.02.2024   Bulletin 2024/07**

(21) Numéro de dépôt: **20820955.1**

(22) Date de dépôt: **11.12.2020**

(51) Classification Internationale des Brevets (IPC):
***G01R 31/382*** *(2019.01)*    ***G01R 31/392*** *(2019.01)*

(52) Classification Coopérative des Brevets (CPC):
**G01R 31/382; G01R 31/392;** Y02E 60/10

(86) Numéro de dépôt international:
**PCT/EP2020/085692**

(87) Numéro de publication internationale:
**WO 2021/122355 (24.06.2021 Gazette 2021/25)**

(54) **PROCÉDÉ DE DÉTERMINATION D'UN SIGNAL SONDE, PROCÉDÉ DE CARACTÉRISATION UTILISANT UN TEL SIGNAL ET DISPOSITIF ASSOCIÉ**

VERFAHREN ZUR BESTIMMUNG EINES SONDENSIGNALS, CHARAKTERISIERUNGSVERFAHREN UNTER VERWENDUNG EINES SOLCHEN SIGNALS UND VORRICHTUNG DAFÜR

METHOD FOR DETERMINING A PROBE SIGNAL, CHARACTERISATION METHOD USING SUCH A SIGNAL AND DEVICE THEREOF

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **16.12.2019  FR 1914516**

(43) Date de publication de la demande:
**26.10.2022   Bulletin 2022/43**

(73) Titulaire: **Commissariat à l'Energie Atomique et aux Energies Alternatives**
**75015 Paris (FR)**

(72) Inventeurs:
• **GUILLET, Nicolas**
  **38054 GRENOBLE CEDEX 09 (FR)**
• **LESPINATS, Sylvain**
  **38054 GRENOBLE CEDEX 09 (FR)**

(74) Mandataire: **Cabinet Camus Lebkiri**
**25 rue de Maubeuge**
**75009 Paris (FR)**

(56) Documents cités:
**WO-A1-2018/090678     FR-A1- 3 080 458**
**US-A1- 2013 091 950**

**Description**

**DOMAINE TECHNIQUE DE L'INVENTION**

Le domaine technique de l'invention est celui du diagnostic non intrusif des systèmes électrochimiques de conversion de l'énergie.
La présente invention concerne plus particulièrement un procédé utilisant des techniques de caractérisation acoustique.

**ARRIERE-PLAN TECHNOLOGIQUE DE L'INVENTION**

Les systèmes de surveillance et de gestion de batterie sont indispensables afin de satisfaire de la manière la plus efficace possible aux demandes des utilisateurs. De manière générale, les systèmes de surveillance et de gestion prennent en compte l'état de charge de la batterie, l'état de santé de la batterie et/ou l'état de sécurité de la batterie (par ex. par la détection d'un fonctionnement anormal). Ces différentes informations sont généralement obtenues par la mesure de grandeurs électriques aux bornes de la batterie, mais également par des données externes telles que celles fournies par les techniques d'analyse thermique (mesure de température et/ou de flux de chaleur) ou de contrôle non destructif (caractérisation acoustique par exemple). A partir des informations obtenues par les mesures, le système de gestion régule le fonctionnement de la batterie pour en optimiser les performances et garantir la sécurité de l'ensemble.
Les techniques de surveillance des batteries en fonctionnement par signaux acoustiques ultrasonore actuellement proposées (Gold et al., 2017; Sood, Pecht, & Osterman, 2016; Steingart et al., 2016, DE102015210266A1) présentent cependant certains inconvénients. Tout d'abord, elles ne s'intéressent qu'à certains paramètres de fonctionnement de la batterie indépendamment les uns des autres (état de charge, état de santé, température) et ne prennent pas en considération l'ensemble des informations contenues dans le signal acoustique mesuré. Bien souvent, les signaux utilisés pour l'interrogation acoustique se limitent à quelques impulsions de très courte durée. Les caractéristiques du signal acoustique utilisées sont alors essentiellement le temps de vol (intervalle de temps entre l'émission du signal et sa réception - voir les documents US 20180120168A1, US20180120261A1 et US 1,132,781 B2).
Les paramètres de fonctionnement sont alors estimés à partir d'une information très succincte. A titre d'exemple, une même caractéristique du signal acoustique mesurée, le temps de vol, qui ne comporte pas beaucoup d'information en lui-même, peut ainsi être utilisé pour estimer tout à la fois la température (US 2018/0120168 A1), l'état de charge ou bien encore l'état de santé (US 2016/0197382 A1) d'une batterie.
D'autres documents pertinents pour l'état de la technique sont FR 3 080 458 A1, US 2013/091950 A1 et WO 2018/090678 A1.
S'il ne fait pas de doute que des informations relatives à la température, l'état de charge et l'état de santé sont contenues dans la valeur du temps de vol, il paraît difficile de déterminer chacun de ces paramètres indépendamment des autres s'ils évoluent tous au cours du fonctionnement de la batterie.
Généralement, les méthodes qui peuvent être utilisées pour estimer la température et les paramètres de fonctionnement (ou d'état) que sont l'état de charge et l'état de santé à partir de l'évolution des signaux acoustiques transmis sont basées sur une méthode d'apprentissage machine. Cette méthode nécessite tout d'abord une étape d'apprentissage au cours de laquelle il sera établi une corrélation entre une caractéristique du signal acoustique mesurée (par exemple de temps de vol du signal acoustique) et un paramètre d'état connu (par exemple l'état de charge). Plusieurs mesures sont nécessaires pour que l'apprentissage se fasse sur la totalité de la plage de fonctionnement de la batterie (typiquement entre 0 et 100 % de l'état de charge). Pour réduire le nombre de points nécessaire pour l'apprentissage, il est possible d'échantillonner ces points sur la plage de fonctionnement (par exemple tous les 5 ou 10 % d'état de charge) et, entre deux points utilisés pour l'apprentissage, d'établir la corrélation entre le paramètre de fonctionnement et les mesures issues du signal acoustique avec une fonction mathématique spécifique (linéaire, exponentielle, puissance, etc...).
Il en résulte que l'apprentissage doit être réalisé sur l'ensemble des plages de fonctionnement de la batterie relatives aux paramètres qui vont avoir une influence notable sur la réponse au signal acoustique. C'est le cas pour l'état de charge mais aussi pour la température de la batterie et éventuellement pour le courant électrique qui la traverse. Pour garantir une estimation précise de l'état de charge d'une batterie à partir du signal acoustique, il est nécessaire d'établir une corrélation entre l'état de charge et le signal acoustique sur toutes les plages d'état de charge et ce, dans toutes les conditions de température et de courant en charge et en décharge admises pour le fonctionnement de la batterie.
Un tel apprentissage nécessite donc un très grand nombre de mesures. En outre, cet apprentissage n'est valable que si le système est stabilisé et que la réponse acoustique est parfaitement répétable. Malheureusement, au cours du vieillissement, le signal acoustique transmis va évoluer et l'apprentissage ne sera plus valide. L'estimation fournie par l'algorithme perdra progressivement en fiabilité sans qu'il soit possible de quantifier cette erreur.

Il existe donc un besoin d'une méthode permettant d'estimer précisément et de manière robuste les valeurs des principaux indicateurs d'états et paramètres de fonctionnement (température par exemple) à partir des signaux acoustiques transmis tout en s'affranchissant au moins en partie des problèmes présentés ci-dessus. Il existe également un besoin d'une méthode qui permet de vérifier la validité des estimations produites.

**RESUME DE L'INVENTION**

L'invention offre une solution aux problèmes évoqués précédemment, en permettant de déterminer un signal sonde optimisé pour le suivi d'un système électrochimique et d'utiliser un tel signal sonde pour établir une corrélation entre au moins un paramètre de fonctionnement du système et une pluralité de caractéristiques de la réponse du système audit signal sonde.

Un aspect de l'invention concerne un procédé de détermination d'un signal sonde pour la caractérisation acoustique d'un système électrochimique, la détermination du signal sonde se faisant à l'aide d'un signal d'indentification émis dans un système électrochimique de référence de sorte à induire une réponse du système électrochimique de référence, le procédé comprenant, pour une pluralité de points de fonctionnement {$PF_i$} du système électrochimique de référence, chaque point de fonctionnement $PF_i$ étant défini par au moins un paramètre de fonctionnement $wp_j^i$ du système électrochimique de référence :

- une étape d'émission du signal d'identification, le signal d'identification étant composé d'une pluralité de fréquences sur une bande passante prédéterminée et étant choisi de sorte à établir un régime stationnaire au sein du système électrochimique de référence et à induire une réponse linéaire au sein du système électrochimique de référence ;
- une étape de mesure de la réponse du système électrochimique de référence au signal d'identification ;

de sorte à obtenir une pluralité de réponse du système électrochimique de référence, chaque réponse étant associée à un point de fonctionnement donnée $PF_i$ ; le procédé comprenant en outre :

- une étape de détermination des corrélations entre le ou les paramètres de fonctionnement $wp_j^i$ définissant le point de fonctionnement $PF_i$ considéré et au moins une caractéristique de la réponse du système électrochimique de référence ;
- une étape de détermination d'un signal sonde à partir de la ou des caractéristiques $wp_i$ présentant une corrélation avec le ou les paramètres de fonctionnement $wp_i$ au-dessus d'une valeur seuil prédéterminée.

Le signal sonde obtenu grâce au procédé selon un premier aspect de l'invention est adapté au système à caractériser, aux paramètres de fonctionnement du système que l'on souhaite déterminer et aux caractéristiques de la réponse les plus adaptées à la caractérisation en question.

Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles.

Dans un mode de réalisation, la réponse du système électrochimique est associée à au moins une caractéristique temporelle $ct_i$ et/ou à au moins une caractéristique fréquentielle $cf_i$.

Dans un mode de réalisation, la variation de la ou des caractéristiques de la réponse du système électrochimique entre deux valeurs extrêmes du paramètre de fonctionnement $wp_i$ ou d'au moins un paramètre de fonctionnement $wp_i$ parmi les paramètres de fonctionnement $wp_i$ est également prise en compte lors de l'étape de détermination d'un signal sonde.

Un deuxième aspect de l'invention concerne un procédé de caractérisation acoustique d'un système électrochimique au moyen d'un signal sonde obtenu à l'aide d'un procédé selon un premier aspect de l'invention, le procédé comprenant une phase d'apprentissage permettant d'établir des corrélations entre au moins un paramètre de fonctionnement $wp_i$ du système électrochimique et au moins deux caractéristiques de la réponse du système électrochimique au signal sonde choisies parmi au moins une caractéristique temporelle $ct_i$ et/ou au moins une caractéristique fréquentielle $cf_i$ ; et une phase de caractérisation de l'état du système électrochimique comprenant :

- une étape d'émission du signal sonde dans le système électrochimique de sorte à induire une réponse dans le système électrochimique ;
- une étape d'enregistrement de la réponse du système électrochimique au signal sonde, l'enregistrement concernant les caractéristiques de la réponse choisies ;

- une étape de détermination du ou des paramètres de fonctionnement $wp_i$ à partir des caractéristiques de la réponse enregistrées lors de l'étape d'enregistrement de la réponse et à partir des corrélations déterminées lors de la phase d'apprentissage.

Outre les caractéristiques qui viennent d'être évoquées dans le paragraphe précédent, le procédé selon un deuxième aspect de l'invention peut présenter une ou plusieurs caractéristiques complémentaires parmi les suivantes, considérées individuellement ou selon toutes les combinaisons techniquement possibles.

Dans un mode de réalisation, les corrélations établies lors de la phase d'apprentissage concernent au moins un premier paramètre de fonctionnement $wp_i$ et un deuxième paramètre de fonctionnement, dit paramètre de test $wp_{test}$, lesdits paramètres ayant été pris en compte lors de la détermination du signal sonde, et la phase de caractérisation comprend :

- une étape de mesure du paramètre de test $wp_{test}$ cette étape de mesure étant concomitante à l'étape d'émission du signal sonde de la phase de caractérisation ;
- après l'étape de détermination du ou des paramètres de fonctionnement $wp_i$, une étape d'évaluation de la précision de la détermination en fonction de la valeur mesurée du paramètre de test $wp_{test}$ et la valeur déterminée à l'aide des corrélations de ce même paramètre.

Dans un mode de réalisation, lors de la phase de caractérisation, lorsque la précision évaluée lors de l'étape d'évaluation de la précision est en-dessous d'un seuil prédéterminé, la valeur du ou des paramètres déterminés à l'aide des corrélations est invalidée.

Dans un mode de réalisation, lors de la phase de caractérisation, lorsque les valeurs des paramètres de fonctionnement $wp_j$ sont invalidées, la valeur de ces paramètres de fonctionnement $wp_j$ est déterminée en fonction de la dernière valeur connue desdits paramètres.

Dans un mode de réalisation, les étapes de la phase de caractérisation sont répétées à intervalles réguliers et dans lequel, lorsque durant un nombre d'itérations successives supérieur ou égal à un seuil prédéterminé, la valeur du ou des paramètres de fonctionnement $wp_j$ déterminée à l'aide des corrélations est invalidée, la phase de caractérisation (PC) comprenant une étape de détection d'un défaut de fonctionnement du système électrochimique.

Dans un mode de réalisation, la phase d'apprentissage comporte, pour au moins un système électrochimique étalon et pour chaque point de fonctionnement $PF_i$ d'une pluralité de point de fonctionnement $\{PF_i\}$ :

- une étape d'émission du signal sonde de sorte à induire une réponse dans le système électrochimique ;
- une étape de mesure du ou des paramètres de fonctionnement $wp_i$ du système électrochimique étalon relatif au point de fonctionnement $CF_i$, cette étape de mesure étant concomitante à l'étape d'émission du signal sonde ;
- une étape d'enregistrement de la réponse du système électrochimique au signal sonde, l'enregistrement concernant au moins deux caractéristiques de la réponse choisies parmi au moins une caractéristique temporelle $ct_i$ et/ou au moins une caractéristique fréquentielle $cf_i$ ;

de sorte à obtenir une pluralité d'enregistrement de la réponse ; la phase d'apprentissage comprenant en outre une étape de détermination des corrélations entre le ou les paramètres de fonctionnement $wp_i$ mesurés et les caractéristiques de la réponse choisies.

Dans un mode de réalisation, lors de l'étape de détermination des corrélations, chaque paramètre de fonctionnement $wp_i$ est pondéré.

Dans un mode de réalisation, une pluralité de paramètres de fonctionnement $\{wp_i\}$ est mesurée lors de l'étape de mesure du ou des paramètres de fonctionnement $wp_i$ et, lors de l'étape de détermination des corrélations, la détermination des corrélations pour un paramètre de fonctionnement donné $wp_i$ prend en compte les autres paramètres de fonctionnement $wp_j$.

Un troisième aspect de l'invention concerne un dispositif comprenant les moyens configurés pour mettre en oeuvre un procédé selon un premier ou un deuxième aspect de l'invention.

Un quatrième aspect de l'invention concerne un programme d'ordinateur comprenant des instructions qui, lorsque le programme est exécuté par un ordinateur, conduisent celui-ci à mettre en oeuvre le procédé selon le premier ou le deuxième aspect de l'invention.

Un cinquième aspect de l'invention concerne un support de données lisible par ordinateur, sur lequel est enregistré le programme d'ordinateur selon un quatrième aspect de l'invention.

Un sixième aspect de l'invention concerne un procédé de gestion d'un système électrochimique mettant en oeuvre un procédé selon un premier ou un deuxième aspect de l'invention.

L'invention et ses différentes applications seront mieux comprises à la lecture de la description qui suit et à l'examen des figures qui l'accompagnent.

**BREVE DESCRIPTION DES FIGURES**

Les figures sont présentées à titre indicatif et nullement limitatif de l'invention.

La [Fig. 1] montre un ordinogramme d'un procédé selon un premier aspect de l'invention.

La [Fig. 2] montre une représentation schématique d'un procédé selon un premier aspect de l'invention.

La [Fig. 3] montre les valeurs minimales et maximales de densité spectrale de puissance de la réponse au cours d'un cyclage complet charge - décharge d'une batterie.

La [Fig. 4] montre l'évolution du coefficient de détermination (qualité de la prédiction d'une régression linéaire) entre la densité spectrale de la réponse et l'état de charge de la batterie au cours d'un cycle de charge - décharge complet.

La [Fig. 5] montre l'évolution en fonction de la fréquence d'un indicateur agrégé prenant en compte le coefficient de détermination entre la densité spectrale de puissance de la réponse et l'état de charge et l'écart maximum mesuré de la variation de la densité spectrale de puissance de la réponse de la batterie au cours d'un cycle de charge - décharge complet.

La [Fig. 6] montre un ordinogramme d'un procédé selon un deuxième aspect de l'invention.

La [Fig. 7] montre une représentation schématique d'un procédé selon un deuxième aspect de l'invention.

La [Fig. 8] montre un ordinogramme de la phase d'apprentissage d'un procédé selon un deuxième aspect de l'invention.

La [Fig. 9] montre un graphique illustrant l'évolution de l'état de charge d'un système électrochimique au cours du temps utilisé pour la phase d'apprentissage.

La [Fig. 10] montre un ordinogramme de la phase de caractérisation d'un procédé selon un deuxième aspect de l'invention.

La [Fig. 11] montre la corrélation entre l'erreur dans la détermination de l'état de charge et l'erreur dans la détermination de la tension aux bornes du système électrochimique.

La [Fig. 12] montre la mesure d'un facteur de qualité de la détermination à partir des corrélations.

**DESCRIPTION DETAILLEE**

Sauf précision contraire, un même élément apparaissant sur des figures différentes présente une référence unique.

Détermination d'un signal sonde

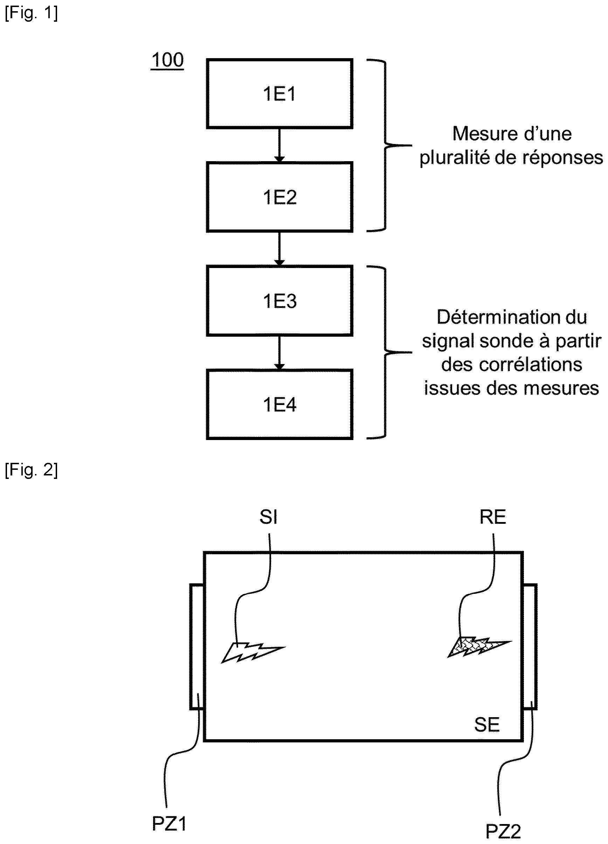

Un premier aspect de l'invention illustré à la [Fig. 1] et la [Fig. 2] concerne un procédé 100 de détermination d'un signal sonde SS pour la caractérisation acoustique d'un système électrochimique SE. Dans le procédé 100 selon un premier aspect de l'invention, la détermination du signal sonde SS se fait à l'aide d'un signal d'indentification SI émis dans un système électrochimique SE de référence de sorte à induire une réponse RE acoustique du système électrochimique SE de référence. Le système électrochimique SE de référence pourra être une batterie, une pile à combustible ou, plus généralement, tout système électrochimique de conversion de l'énergie.

Le procédé 100 selon un premier aspect de l'invention comprend une étape 1E1 d'émission du signal d'identification SI, le signal d'identification SI étant composé d'une pluralité de fréquences sur une bande passante prédéfinie, le signal d'identification SI étant choisi de sorte à établir un régime stationnaire au sein du système électrochimique SE et à induire une réponse linéaire au sein du système électrochimique SE. La largeur de bande passante peut par exemple être choisie en fonction de mesures déjà connues sur un système similaire et/ou en fonction des caractéristiques des moyens utilisés pour générer le signal d'identification SI (ou le signal sonde SS). Le signal d'identification SI pourra par exemple être généré par un transducteur PZ1 piézoélectrique fixé sur le système électrochimique SE.

Il est possible de s'assurer de la réponse linéaire du système électrochimique SE en vérifiant, pour un signal d'identification SI donné, qu'à une légère variation de l'amplitude dudit signal SI aux différentes fréquences composant le signal d'identification SI est associée une variation linéaire de la puissance transmise. Si cette linéarité n'est pas observée, il est alors nécessaire de diminuer l'amplitude du signal d'identification SI jusqu'à obtenir une telle linéarité. De préférence, cette linéarité sera vérifiée pour chaque fréquence du signal d'identification SI.

L'établissement d'un régime stationnaire impose quelques restrictions sur le signal d'identification SI utilisé : il est généralement difficile d'utiliser un signal d'identification SI établi de manière aléatoire (bruit blanc ou autres bruits colorés) car ce caractère aléatoire ne permet pas d'établir un régime stationnaire. En effet, ce dernier peut nécessiter plusieurs dizaines de micro secondes pour s'établir (plusieurs périodes successives à chaque fréquence). Par exemple, le signal d'identification SI peut être obtenu en procédant à un balayage en fréquence entre deux valeurs extrêmes telles que $f_{min}$ = 10kHz et $f_{max}$ = 1MHz selon une variation linéaire ou logarithmique de la fréquence avec le temps. De manière alternative, le signal d'identification SI peut être plus simple (par ex. quelques fréquences ponctuelles choisies à partir de connaissances antérieures sur des systèmes électrochimiques SE identiques ou similaires) ou plus complexes (sélection aléatoire d'un échantillonnage de fréquences). Par ailleurs, l'amplitude du signal d'identification SI peut être choisie constante sur toute la gamme de fréquence ou variable avec des variations monotones ou complexes de l'amplitude avec la fréquence.

Le procédé comprend ensuite une étape 1 E2 de mesure de la réponse RE du système électrochimique SE au signal d'indentification SI. Cette réponse RE peut par exemple être mesurée au moyen d'un transducteur PZ2 piézoélectrique fixé sur le système électrochimique SE. Ce transducteur pourra être le même que celui ayant généré le signal d'identification SI ou bien alors un transducteur différent de celui-ci.

La réponse RE du système électrochimique SE (c'est-à-dire le signal acoustique transmis) contient un grand nombre d'informations relatives aux propriétés physiques des matériaux qui composent le système électrochimique SE et aux variations de ces propriétés physiques au cours du fonctionnement du système électrochimique SE en question. Par exemple, la température peut faire varier les propriétés physiques de l'ensemble des matériaux qui composent le système électrochimique SE (électrodes, électrolyte, séparateur, collecteur de courant, emballage etc...) avec des variations de densité et du module d'élasticité. De même, l'état de charge du système électrochimique SE peut avoir une influence directe sur les propriétés physiques des électrodes (changement de structure cristalline, variation de volume) et également sur celles de l'électrolyte pour certaines chimies de batteries (Pb-acide, Ni-Cd, Ni-MH, batteries à circulation, etc...) dont la densité de l'électrolyte évolue avec l'état de charge. De la même façon, l'état de santé va avoir une influence sur l'ensemble des matériaux du système électrochimique SE. Suivant les mécanismes de vieillissements propres à chaque système électrochimique SE certains matériaux seront plus impactés que d'autres. Bien souvent, c'est une variation de densité du système électrochimique SE qui est observée (généralement du fait d'un gonflement due à une accumulation de gaz produit par dégradation de l'électrolyte).

Ces deux étapes sont mises en oeuvre pour une pluralité de points de fonctionnement $\{PF_i\}$ du système électrochimique SE, chaque point de fonctionnement $PF_i$ étant défini par au moins un paramètre de fonctionnement $wp_j^i$ du système électrochimique SE, de préférence par une pluralité de paramètre de fonctionnement $\{wp_j^i\}$ où $i$ est l'indice relatif au point de fonctionnement $PF_i$ considéré et $j$ est l'indice du paramètre de fonctionnement relatif au point de fonctionnement $PF_i$ considéré (lorsqu'il est fait référence à un paramètre de fonctionnement de manière générale, c'est-à-dire sans faire référence à un point de fonctionnement en particulier, l'indice relatif au point de fonctionnement est omis). Pour donner quelques exemples, un paramètre de fonctionnement $wp_j$ selon l'invention peut être l'état de charge, l'état de santé, la tension aux bornes du système électrochimique SE, la température du système électrochimique, etc.

Ainsi, une pluralité de réponses RE du système électrochimique SE est obtenue, chaque réponse RE étant associée à un point de fonctionnement donnée $PF_i$ défini par un ou plusieurs paramètres de fonctionnement $wp_j^i$. En effet, pour évaluer l'influence des paramètres de fonctionnement $wp_j$ sur la réponse RE du système électrochimique SE, il est préférable de disposer de mesures réalisées pour différents points de fonctionnement $PF_i$ (c'est-à-dire dans différentes conditions de fonctionnement). Pour donner un exemple, les deux étapes décrites précédemment peuvent être mises en oeuvre au cours d'une pluralité de cycles charge - décharge à un régime nominal défini selon l'application visée et les données techniques fournies par le fabricant et pour deux températures différentes. Ces deux températures peuvent par exemple être les valeurs extrêmes de l'utilisation envisagée. Dans cet exemple, chaque point de fonctionnement $PF_i$ sera défini au moyen des paramètres de fonctionnements suivants : l'état de charge du système électrochimique SE, la température du système électrochimique SE et, éventuellement, l'état de santé du système électrochimique SE. Il ne s'agit bien entendu que d'un exemple et la pluralité de points de fonctionnement $\{PF_i\}$ du système électrochimique SE pourra être choisie différemment.

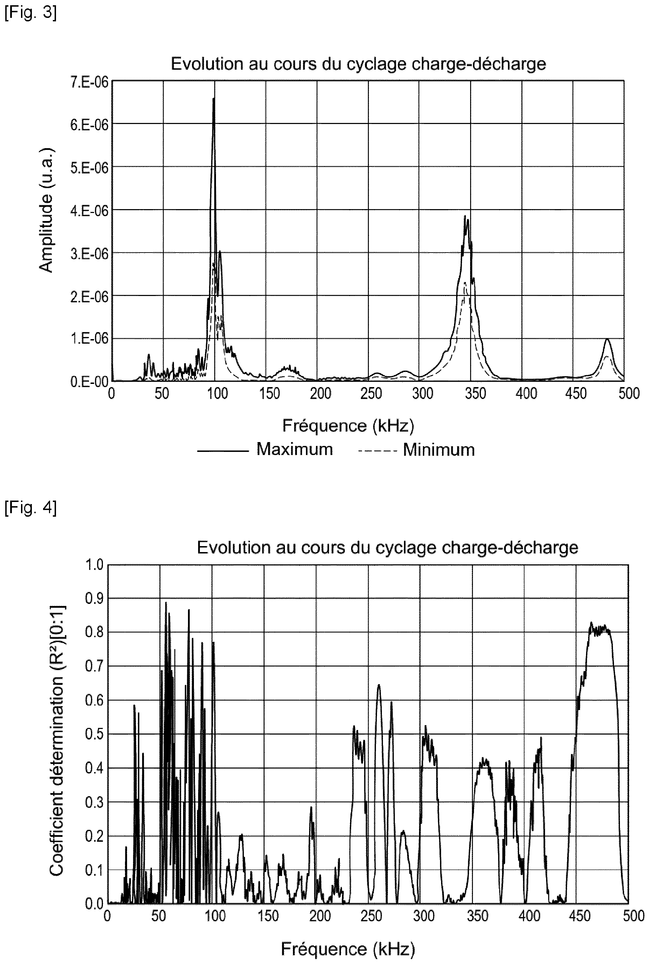

Un exemple d'une mesure de la densité spectrale de puissance de la réponse RE lors du cyclage d'un système électrochimique (ici une batterie) est illustré à la [Fig. 3], le paramètre de fonctionnement $wp_i$ considéré étant ici l'état de charge. Cette figure présente en abscisse la fréquence considérée de la réponse RE du système électrochimique SE et en ordonnée la valeur minimale et la valeur maximale de la densité spectrale mesurées lors du cyclage pour la fréquence considérée, la courbe en trait épais correspondant à la valeur maximale et la courbe en trait fin correspondant à la valeur minimale. Dans cet exemple, le signal d'identification SI a été obtenu par balayage en fréquence entre 20 et 500 kHz. La densité spectrale de puissance de la réponse RE du système électrochimique SE évolue fortement avec la fréquence. Plus particulière, la réponse RE du système électrochimique SE est très forte autour de 100 kHz et 350 kHz. En revanche, elle est très faible entre 200 et 250 kHz ou entre 400 et 450 kHz.

Une fois cette pluralité de réponses RE obtenue, le procédé comprend une étape 1E3 de détermination de la corrélation entre au moins un paramètre de fonctionnement $wp_j$ et au moins une caractéristique de la réponse RE du système électrochimique SE. De préférence, la corrélation est évaluée à l'aide du coefficient de corrélation et/ou du coefficient de détermination (généralement noté $R^2$). En reprenant le même exemple que la [Fig. 3], la [Fig. 4] illustre le coefficient de détermination entre l'état de charge du système électrochimique SE et la densité spectrale de puissance de la réponse RE du système électrochimique SE pour une fréquence donnée. Comme le montre cette figure, le coefficient de détermination peut fortement évoluer avec la fréquence du signal d'identification SI. Notamment, ce coefficient de détermination peut être supérieur à 0,8 pour certaines fréquences, ce qui signifie qu'il existe une assez bonne corrélation (régression linéaire) entre l'état de charge et la valeur de la densité spectrale de puissance de la réponse RE à ces fréquences, tout comme nul à d'autres fréquences (pas de relation linéaire entre les valeurs mesurées). Il est ainsi possible de déterminer les fréquences les plus sensibles à un paramètre de fonctionnement $wp_j$ donné, puis de déterminer un signal sonde SS sur la base de la corrélation entre le paramètre de fonctionnement $wp_j$ considéré et la réponse RE du système électrochimique SE.

Pour cela, le procédé comprend ensuite une étape 1E4 de détermination d'un signal sonde SS à partir de la ou des caractéristiques de la réponse RE présentant une corrélation avec le ou les paramètres de fonctionnement $wp_j$ au-dessus d'une valeur seuil prédéterminée. Pour reprendre l'exemple de la [Fig. 4], le signal sonde SS ainsi déterminé pourra ne comprendre que les fréquences pour lesquelles le coefficient de détermination est supérieure à 0,8.

Il se peut cependant que dans les fréquences retenues se trouvent des fréquences pour lesquelles l'écart d'amplitude de la ou des caractéristiques de la réponse RE entre deux valeurs extrêmes du ou des paramètres $wp_j$ d'intérêt est relativement faible. Cela peut dans certains cas rendre difficile la mesure et donc la détermination du ou des paramètres de fonctionnement $wp_j$ d'intérêt.

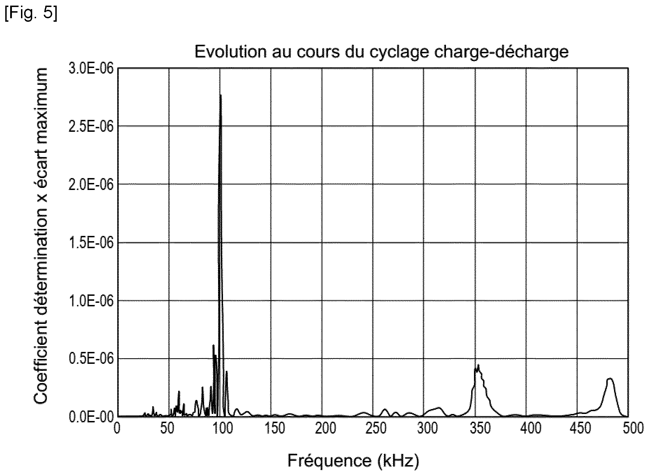

Aussi, dans un mode de réalisation, la variation du ou des caractéristiques (temporelles $ct_i$ et/ou fréquentielles $cf_i$) de la réponse RE (par exemple de la densité spectrale de la réponse RE) du système électrochimique SE entre deux valeurs extrêmes du paramètre de fonctionnement $wp_i$ (lorsque l'on ne s'intéresse qu'à un seul paramètre) ou d'au moins un paramètre de fonctionnement $wp_i$ parmi les paramètres de fonctionnement $wp_i$ (lorsque l'on s'intéresse à une pluralité de paramètres de fonctionnement $wp_i$) est également prise en compte lors de l'étape 1 E4 de détermination d'un signal sonde SS. Dans un exemple de réalisation illustré à la [Fig. 5], cette prise en compte est effectuée à travers un indicateur prenant en compte la variation de la densité spectrale et la corrélation de la réponse du système relativement à un paramètre de fonctionnement $wp_i$, ici l'état de charge. Cette prise en compte peut se faire de différente manière. Par exemple, pour garantir une bonne précision, il est possible de fortement pondérer le coefficient de détermination. Si en revanche la réponse RE du système électrochimique SE pour une fréquence donnée est proche du seuil de détection du capteur PZ2 utilisé pour enregistrer la réponse RE du système électrochimique SE, il est possible d'apporter plus de poids à l'écart d'amplitude du signal au cours du cyclage de sorte à favoriser les fréquences pour lesquelles la variation d'amplitude est la plus élevée. Dans la [Fig. 5], une pondération identique pour la variation et la corrélation (calculée ici à l'aide d'un coefficient de détermination) a été adoptée.

A partir de cet indicateur agrégé (égal au produit entre le coefficient de détermination et l'écart d'amplitude maximal au cours du cyclage), il est ensuite possible de sélectionner les fréquences venant composer le signal sonde SS. Notamment, la valeur de cet indicateur est très importante autour de 100 kHz, 350 kHz et 480 kHz. Aussi, il est possible de ne sélectionner que certaines fréquences pour lesquelles la valeur de l'indicateur agrégé est supérieure à une valeur seuil ou ne sélectionner que les fréquences pour lesquelles cet indicateur agrégé présente les plus fortes valeurs (par exemple ne sélectionner que les fréquences pour lesquelles l'indicateur agrégé est dans les 10 % les plus importants).

## Caractéristique d'intérêt de la réponse RE

Les informations contenues dans la réponse RE du système électrochimique SE pouvant être utilisées dans un procédé 100 selon un premier aspect de l'invention ou un procédé 200 selon un deuxième aspect de l'invention (qui sera présenté dans la suite) sont de différentes natures :

- les caractéristique temporelles $ct_i$ : le temps de vol du signal, la durée du signal réceptionné, la forme d'onde (variation d'amplitude en fonction du temps), l'intervalle de temps entre le début de la réception de l'onde et l'amplitude maximale etc. ;
- les caractéristiques fréquentielles $cf_i$ : la densité spectrale de puissance (puissance du signal transmis pour chaque fréquence qui compose le signal), la fréquence moyenne, l'énergie du signal, sa force, etc.

De manière générale, les caractéristiques fréquentielles $cf_i$ sont obtenues en réalisant une transformée de Fourier de la réponse RE du système électrochimique SE. Toutes ces informations peuvent être collectées et enregistrées dans une mémoire, par exemple sous la forme d'un tableau dont chaque ligne correspond au temps auquel a été mesuré la réponse RE du système électrochimique SE à un signal d'identification SI ou à un signal sonde SS et qui est composé de plusieurs colonnes relatives aux caractéristiques temporelles $ct_i$ et fréquentielles $cf_i$ (par exemple plusieurs milliers de colonnes pour la forme d'onde et 1024 colonnes pour la densité spectrale de puissance).

Toutefois, toutes les caractéristiques de la réponse RE ne sont pas pertinentes, mais dépendent du type de système électrochimique SE étudié, de son format et/ou du ou des paramètres de fonctionnement $wp_j$ qui doivent être estimés. Lorsque l'on utilise un signale sonde SS déterminé à l'aide d'un procédé 100 selon un premier aspect de l'invention pour la caractérisation d'un système électrochimique SE, il est donc préférable de concentrer l'analyse de la réponse RE du système électrochimique SE au signal sonde SS ainsi déterminé sur le ou les paramètres de fonctionnement $wp_j$ et le ou les caractéristiques (par ex. temporelles $ct_i$ et/ou fréquentielles $cf_i$) de la réponse RE pour lequel ou pour lesquels le signal sonde SS a été déterminé à l'aide dudit procédé 100.

### Caractérisation acoustique d'un système électrochimique

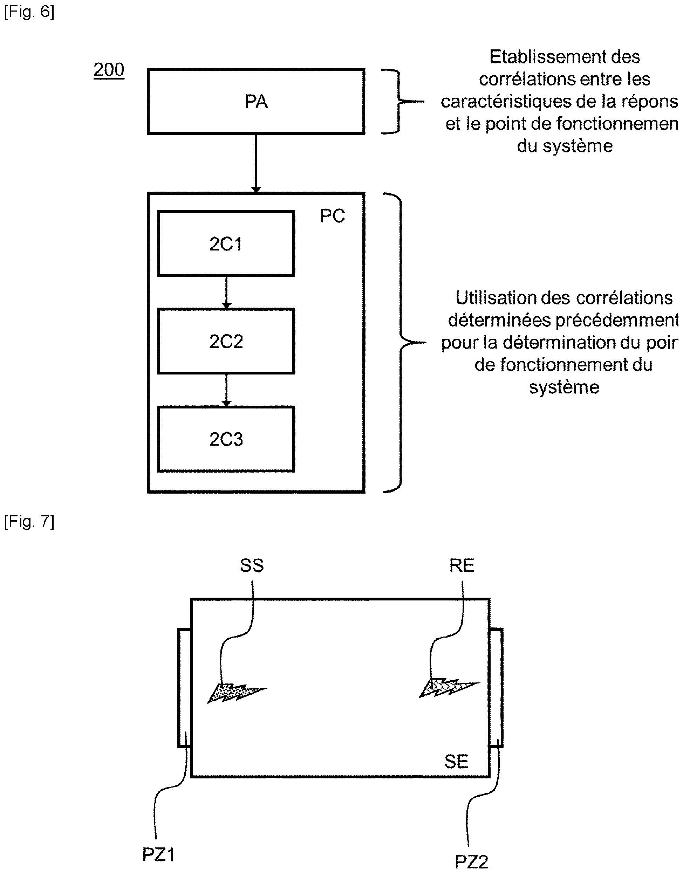

Une fois qu'un signal sonde SS a été déterminé à l'aide d'un procédé 100 selon un premier aspect de l'invention, il est possible d'utiliser un tel signal sonde SS pour caractériser de manière acoustique le point de fonctionnement $PF_i$ d'un système électrochimique SE, par exemple une batterie. Plus particulièrement, la caractérisation va concerner le ou les paramètres de fonctionnement $wp_j$ ayant été pris en compte lors de la détermination du signal sonde SS et va prendre en compte le ou les caractéristiques de la réponse RE du système électrochimique SE prises en compte lors de la détermination du signal sonde SS. Pour cela, un deuxième aspect de l'invention illustré à la [Fig. 6] et à la [Fig. 7] concerne un procédé 200 de caractérisation acoustique d'un système électrochimique SE au moyen d'un signal sonde SS obtenu à l'aide d'un procédé 100 comme décrit ci-dessus en prenant en compte au moins un paramètre de fonctionnement $wp_j$ du système électrochimique SE et au moins deux caractéristiques de la réponse RE du système électrochimique SE au signal sonde SS choisies parmi au moins une caractéristique temporelle $ct_i$ et/ou au moins une caractéristique fréquentielle $cf_i$ (par ex. les deux caractéristiques pourront être deux caractéristiques temporelles $ct_i$, deux caractéristiques fréquentielles $cf_i$ ou une caractéristique temporelle $ct_i$ et une caractéristique fréquentielle $cf_i$). Le procédé 200 selon un deuxième aspect de l'invention comprend une phase PA d'apprentissage permettant d'établir des corrélations entre le ou les paramètres de fonctionnement $wp_j$ du système électrochimique SE et les caractéristiques de la réponse RE du système au signal sonde SS choisies (c'est-à-dire choisies parmi au moins une caractéristique temporelle $ct_i$ et/ou au moins une caractéristique fréquentielle $cf_i$). Le procédé 200 selon un deuxième aspect de l'invention comprend également une phase PC de caractérisation de l'état du système électrochimique.

### Phase d'apprentissage

Comme déjà mentionné, le procédé selon un deuxième aspect de l'invention comprend une phase PA d'apprentissage. Cette phase PA d'apprentissage peut être opérée sur un système électrochimique SE étalon ou bien encore sur une pluralité de systèmes électrochimiques SE étalon. Elle peut également être opérée sur le système électrochimie SE cible, c'est-à-dire sur le système électrochimique SE sur lequel va être mis en oeuvre la phase PC de caractérisation qui sera décrite dans la suite.

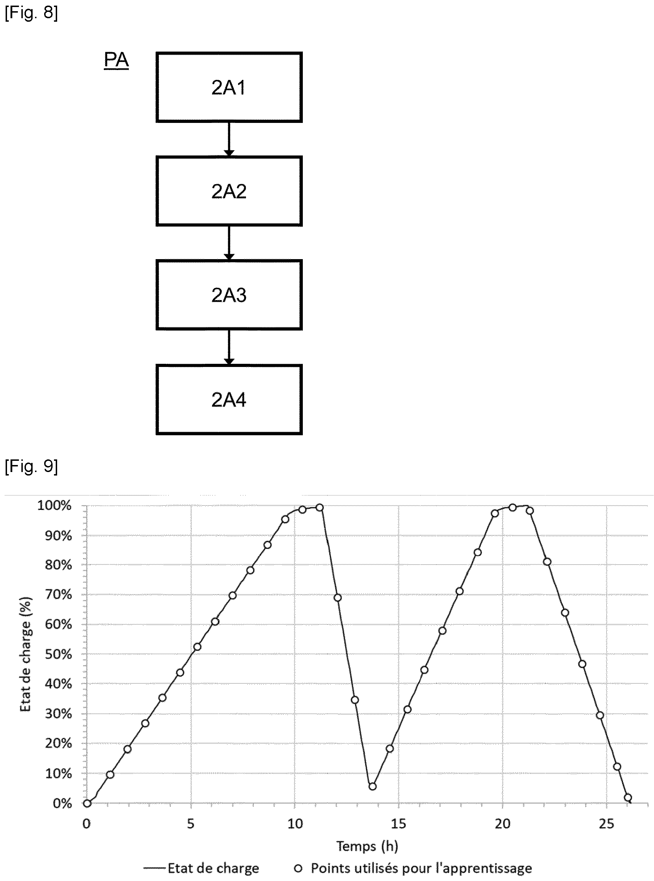

Comme illustré à la [Fig. 8], cette phase PA d'apprentissage comprend pour chaque système électrochimique SE étalon et pour chaque point de fonctionnement $PF_i$ d'une pluralité de point de fonctionnement $\{PF_i\}$, une étape 2A1 d'émission d'un signal sonde SS de sorte à induire une réponse RE dans le système électrochimique SE étalon. Ce signal sonde SS ayant été obtenu à l'aide d'un procédé 100 selon un premier aspect de l'invention, il permet d'établir un régime stationnaire au sein du système électrochimique SE et d'induire une réponse RE linéaire au sein du système électrochimique SE. La pluralité de points de fonctionnement $\{PF_i\}$ pourra par exemple correspondre à un ou plusieurs cycles de charge/décharge effectués pour une ou plusieurs températures de fonctionnement et/ou pour une ou plusieurs valeurs de courant de charge/décharge. Bien entendu, il est possible de prendre en compte d'autres paramètres de fonctionnement $wp_j$, les paramètres de fonctionnement $wp_j$ pris en compte lors de la phase PA d'apprentissage étant de préférence compris dans les paramètres de fonctionnement $wp_j$ pris en compte pour l'établissement du signal sonde SS.

Cette phase PA d'apprentissage comprend également pour chaque système électrochimique SE étalon et pour chaque point de fonctionnement $PF_i$ d'une pluralité de points de fonctionnement {$PF_i$}, une étape 2A2 de mesure d'au moins un paramètre de fonctionnement $wp_j$ (de préférence une pluralité de paramètres de fonctionnement {$wp_j$}) du système électrochimique SE étalon relatif au point de fonctionnement $PF_i$, cette étape de mesure étant concomitante à l'étape 2A1 d'émission du signal sonde SS. De la même manière que précédemment, le ou les paramètres de fonctionnement $wp_j$ mesurés lors de cette étape 2A2 sont compris dans le ou les paramètres de fonctionnement $wp_j$ pris en compte pour l'établissement du signal sonde SS.

Cette phase PA d'apprentissage comprend en outre une étape 2A3 d'enregistrement de la réponse RE du système électrochimique SE au signal sonde SS, l'enregistrement concernant au moins deux caractéristiques de la réponse RE choisies parmi au moins une caractéristique temporelle $ct_i$ de la réponse et/ou au moins une caractéristique fréquentielle $cf_i$ de la réponse RE. De préférence, l'enregistrement concerne une pluralité de caractéristiques temporelles {$ct_i$} et une pluralité de caractéristiques fréquentielles {$cf_i$}.

De plus, ces étapes 2A1, 2A2, 2A3 sont répétées pour une pluralité de point de fonctionnement {$PF_i$} sorte à obtenir une pluralité d'enregistrement de la réponse RE. Ainsi, chaque point de fonctionnement $PF_i$ est caractérisé par au moins un paramètre de fonctionnement $wp_i$, de préférence une pluralité de paramètres de fonctionnement {$wp_j$}, mesurés lors de l'étape 2A2 de mesure d'au moins un paramètre de fonctionnement $wp_j$. De plus, chaque point de fonctionnement $PF_i$ est associé à au moins deux caractéristiques de la réponse RE choisies parmi au moins une caractéristique temporelle $ct_i$ de la réponse (de préférence une pluralité de caractéristiques temporelles {$ct_i$} de la réponse RE) et/ou à au moins une caractéristique fréquentielle $cf_i$ de la réponse (de préférence une pluralité de caractéristiques fréquentielles {$cf_i$} de la réponse RE). Une base de données des points de fonctionnement {$PF_i$} et des réponses RE du système électrochimique SE associées est ainsi constituée.

A partir de ces données, il va être possible, par une méthode d'apprentissage, d'établir des corrélations entre chaque paramètre de fonctionnement $wp_j$ d'une part et les caractéristiques de la réponse RE choisies d'autre part. Pour cela, la phase PA d'apprentissage comprend en outre une étape 2A4 de détermination des corrélations entre le ou les paramètres de fonctionnement $wp_j$ mesurés et les caractéristiques de la réponse RE choisies (c'est-à-dire les au moins deux caractéristiques de la réponse RE choisies parmi au moins une caractéristique temporelle $ct_i$ de la réponse et/ou au moins une caractéristique fréquentielle $cf_i$ de la réponse RE). Il est utile de noter que chaque paramètre $wp_j$ de fonctionnement est ainsi corrélé à au moins une caractéristique temporelle $ct_i$ de la réponse RE et/ou à au moins une caractéristique fréquentielle $cf_i$ de la réponse RE. On entend par là que le paramètre de fonctionnement $wp_j$ est déterminé à partir d'au moins deux caractéristiques de la réponse RE choisies parmi le ou les caractéristiques temporelles $ct_i$ et le ou les caractéristiques fréquentielles $cf_i$ de la réponse RE. Par contraste, dans l'état de la technique, un paramètre de fonctionnement $wp_j$ est en général corrélé à une caractéristique temporelle $ct_i$ (par exemple le temps de vol) ou (il s'agit ici d'un ou exclusif) une caractéristique fréquentielle $cf_i$ (par exemple la fréquence moyenne).

Dans un mode de réalisation, chaque paramètre de fonctionnement $wp_i$ est pondéré lors de l'établissement des corrélations (par exemple, la température du système électrochimique pourra être pondérée de sorte à prendre en compte sa plus grande influence sur les caractéristiques de la réponse RE que le courant qui traverse le système électrochimique SE).

Dans un mode de réalisation, une pluralité de paramètre de fonctionnement {$wp_j$} est mesurée lors de l'étape 2A2 de mesure d'au moins un paramètre de fonctionnement $wp_i$ et, lors de l'étape 2A4 de détermination des corrélations, la détermination des corrélations pour un paramètre de fonctionnement donné $wp_j$ prend en compte les autres paramètres de fonctionnement $wp_k$ avec $k \neq j$. Par exemple, si lors de l'étape 2A2 de mesure d'au moins un paramètre de fonctionnement $wp_j$, l'état de charge et la température sont mesurés, alors lors de l'étape 2A4 de détermination des corrélations, des corrélations seront déterminées entre :

- l'état de charge d'une part et les caractéristiques temporelles $ct_i$ et/ou fréquentielle $cf_i$ de la réponse RE ainsi que la température d'autre part ;
- la température d'une part et les caractéristiques temporelles $ct_i$ et/ou fréquentielle $cf_i$ de la réponse RE ainsi que l'état de charge d'autre part.

Ainsi, si en plus de la réponse RE du système électrochimique, un ou plusieurs paramètres de fonctionnement $wp_j$ sont mesurés lors du fonctionnement du système électrochimique SE, ce ou ces paramètres $wp_j$ pourront être utilisés en plus de la réponse RE du système pour déterminer d'autres paramètres de fonctionnement $wp_i$ non mesurés mais pour lesquels une corrélation a été établie lors de la phase PA d'apprentissage.

Un exemple de phase PA d'apprentissage est illustré à la [Fig. 9]. Dans cet exemple, le paramètre de fonctionnement $wp_j$ utilisé pour l'apprentissage est l'état de charge et les valeurs de ce paramètre sont réparties de manière à peu près uniforme, à intervalles de temps réguliers. Cette répartition n'est cependant pas optimale car durant la première décharge, il n'y a que deux points de fonctionnement $PF_i$ pris en compte. Une conséquence possible est une estimation plus difficile de l'état de charge de la batterie.

*Phase de caractérisation*

La phase PC de caractérisation du procédé 200 selon un deuxième aspect de l'invention comprend une étape 2C1 d'émission du signal sonde SS déterminé à l'aide d'un procédé selon un premier 100 aspect de l'invention dans le système électrochimique SE de sorte à induire une réponse RE dans le système électrochimique SE. Comme mentionné précédemment, le signal sonde SS a été déterminé en prenant en compte au moins un paramètre de fonctionnement $wp_j$ du système électrochimique SE (de préférence une pluralité de paramètre de fonctionnement $\{wp_j\}$) et au moins deux caractéristiques de la réponse RE choisies parmi au moins une caractéristique temporelle $ct_i$ et/ou au moins une caractéristique fréquentielle $cf_i$.

La phase PC de caractérisation comprend également une étape 2C2 d'enregistrement de la réponse RE du système électrochimique SE au signal sonde SS, l'enregistrement concernant les caractéristiques de la réponse RE choisies (c'est-à-dire choisies parmi au moins une caractéristique temporelle $ct_i$ et/ou au moins une caractéristique fréquentielle $cf_i$).

La phase de caractérisation comprend ensuite une étape 2C3 de détermination du ou des paramètres de fonctionnement $wp_j$ à partir des caractéristiques de la réponse RE enregistrées lors de l'étape 2C2 d'enregistrement de la réponse RE et à l'aide des corrélations établies lors de la phase PA d'apprentissage précédemment décrite.

Ainsi, lors de la phase PC de caractérisation, la valeur d'un ou plusieurs paramètres de fonctionnement $wp_j$ est déterminée à partir des corrélations établies lors de la phase PA d'apprentissage. Il peut cependant être intéressant de s'assurer que la valeur ainsi déterminée est déterminée avec une précision suffisante.

*Evaluation au cours du fonctionnement de la précision de la détermination*

Afin d'assurer un suivi de la précision de la valeur du ou des paramètres déterminés à partir des corrélations (autrement dit, vérifier la précision de l'apprentissage), il est possible de mesurer la valeur d'un paramètre de fonctionnement $wp_j$ que l'on désignera paramètre de test $wp_{test}$ tout en déterminant la valeur de ce même paramètre de test $wp_{test}$ au moyen des corrélations établi lors de la phase PA d'apprentissage. Il est ensuite possible de mesurer l'écart entre la valeur mesurée et la valeur déterminée à partir des corrélations et d'en déduire la précision de la détermination à l'aide des corrélations. On choisira de préférence un paramètre de test $wp_{test}$ facile à mesurer comme le courant traversant le système électrochimique SE et/ou la tension aux bornes du système électrochimique SE.

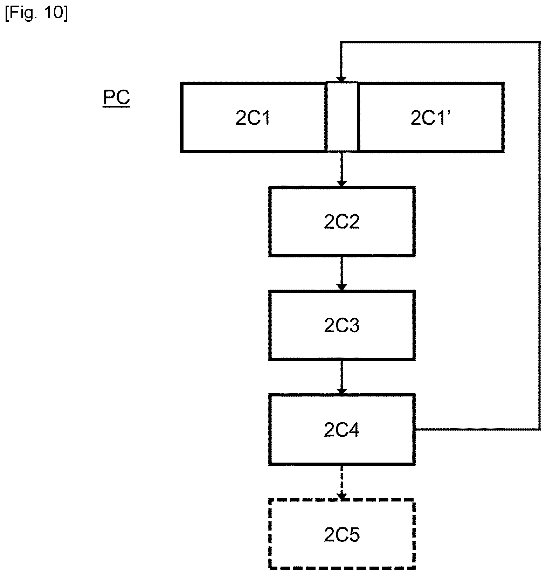

Pour cela, dans un mode de réalisation illustré à la [Fig. 10], un point de fonctionnement $PF_i$ est défini par au moins un premier paramètre de fonctionnement $wp_j$ et un deuxième paramètre de fonctionnement dit paramètre de test $wp_{test}$, lesdits paramètres ayant été pris en compte lors de la détermination du signal sonde SS. De plus, la phase PC de caractérisation comprend une étape 2C1' de mesure du paramètre de test $wp_{test}$, cette étape 2C1' de mesure étant concomitante à l'étape 2C1 d'émission du signal sonde SS de la phase de caractérisation.

De plus, dans ce mode de réalisation, la phase PC de caractérisation comprend, après l'étape 2C3 de détermination du ou des paramètres de fonctionnement $wp_j$ de la phase PC de caractérisation, une étape 2C4 d'évaluation de la précision de la détermination en fonction de la valeur mesurée du paramètre de test $wp_{test}$ et la valeur déterminée à l'aide des corrélations de ce même paramètre $wp_{test}$.

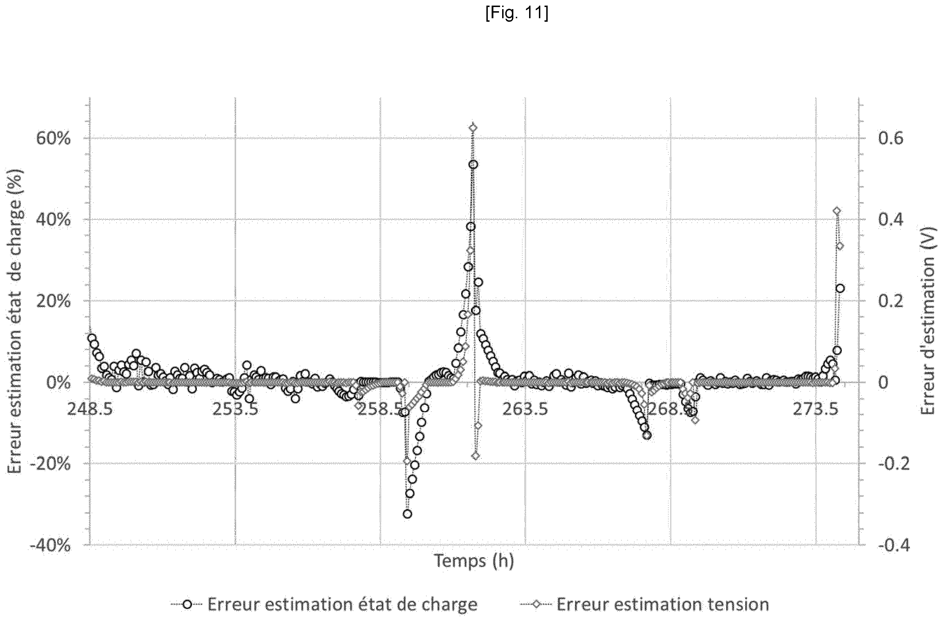

Ainsi, il est possible d'évaluer la précision basée sur l'utilisation des corrélations au cours du fonctionnement du système électrochimique SE en comparant la valeur mesurée d'un paramètre $wp_{test}$ et cette même valeur déterminée à partir des corrélations. Si les deux valeurs sont proches, nous pouvons alors considérer que la détermination à partir des corrélations peut être correcte pour le paramètre $wp_{test}$ en question, mais également pour les autres paramètres déterminés à l'aide des corrélations. Cette propriété est par exemple illustrée à la [Fig. 11] qui montre l'erreur dans la détermination de la valeur de l'état de charge et de la tension aux bornes du système électrochimique SE. On note la forte corrélation entre ces deux erreurs : dans cet exemple l'erreur sur la détermination de la tension à partir des corrélations pourrait être évaluée afin de connaître l'erreur concernant l'état de charge. Plus particulièrement, le première paramètre de fonctionnement serait l'état de charge (déterminé uniquement à partir des corrélations) et le paramètre de test $wp_{test}$ serait la tension aux bornes du système électrochimique SE (déterminée à partir des corrélations mais également mesurée, par exemple à l'aide d'un voltmètre disposé sur le système électrochimique SE, de sorte à estimer l'erreur d'évaluation dudit paramètre de test).

Dans un mode de réalisation, lors de la phase PC de caractérisation, lorsque la précision évaluée lors de l'étape 2C4 d'évaluation de la précision est en-dessous d'un seuil prédéterminé, la valeur du ou des paramètres déterminés à l'aide des corrélations est invalidé. Le seuil prédéterminé peut être défini par l'utilisateur ou bien encore déterminé de manière statistique, par exemple à partir de l'écart type des mesures précédentes. Dans ce dernier cas, les valeurs résultant de l'étape 2C4 d'évaluation sont stockée de sorte à constituer une statistique qui pourra être utilisée ensuite pour déterminer le seuil d'invalidation.

Dans un mode de réalisation, la précision est évaluée à l'aide d'un facteur de qualité défini à partir de l'écart relatif ou absolu entre la valeur mesurée et la valeur déterminée du paramètre de test $wp_{test}$.

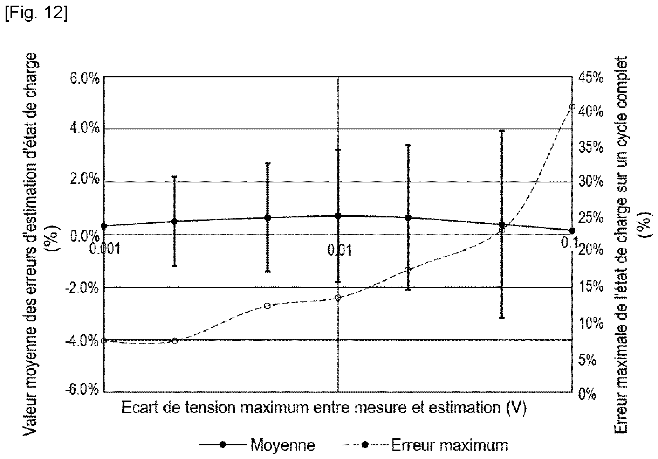

Un exemple de réalisation de ce mode de réalisation est illustré à la [Fig. 12]. Cette figure présente la valeur moyenne (ronds pleins) du facteur de qualité défini par l'écart relatif entre la valeur de l'état de charge mesuré et la valeur de l'état de charge déterminé à partir des corrélations, la valeur maximale (ronds vides) de ce facteur de qualité ainsi que l'écart type de la valeur moyenne de ce facteur (barres d'erreur) sur l'ensemble du cycle contenant deux charges et deux décharges à régimes différents. Ce facteur de qualité est représenté dans le cas où sont considérées les déterminations de l'état de charge pour lesquelles l'écart de tension (pris pour paramètre de test $wp_{test}$) entre la valeur mesurée (par exemple, par le système de gestion de la batterie) et la valeur déterminée à partir des corrélations dépasse des valeurs maximales admises comprises entre 1 mV et 100 mV.

Dans cet exemple, lorsque la valeur maximale d'écart de tension admise est limitée à 10 mV, l'erreur moyenne d'état de charge est de 0,69 % avec un écart type de 2,47 %. Il reste cependant quelques points aberrants pour lesquels la détermination à l'aide des corrélations ne parvient pas à attribuer un état de charge correct à partir de la réponse RE du système électrochimique SE. Par ailleurs, dans cet exemple, l'erreur maximale d'estimation de l'état de charge sur le cycle complet est de 13 %.

Ainsi, toujours en considérant cet exemple, en choisissant une valeur maximale d'écart de tension admise limitée à 2 mV, l'erreur moyenne d'état de charge est légèrement réduite à 0,48 % mais avec un écart type de seulement 1,69 %. Même s'il reste quelques points pour lesquels la détermination à partir des corrélations ne parvient pas à attribuer un état de charge correct à partir de la réponse RE du système SE, l'erreur maximale d'estimation de l'état de charge sur le cycle complet n'est plus que de 7,3 %.

Dans un mode de réalisation, lorsque la valeur du ou des paramètres de fonctionnement $wp_i$ déterminés lors de l'étape 2C3 de détermination du ou des paramètres de fonctionnement $wp_i$ est incompatible avec le régime de fonctionnement du système électrochimique SE, alors la valeur du ou des paramètres de fonctionnement $wp_j$ déterminée à l'aide des corrélations est invalidée. Une telle situation peut se produire lorsque l'état de charge déterminé à l'aide des corrélations est en augmentation alors que le système électrochimique SE est en cours de décharge (par exemple le courant mesuré et éventuellement le courant estimé révèlent un fonctionnement en décharge) ou bien encore lorsque la variation d'état de charge déterminé à l'aide des corrélations est trop rapide pour être compatible avec le fonctionnement du système électrochimique SE.

Dans un mode de réalisation, lors de la phase PC de caractérisation, lorsque les valeurs des paramètres de fonctionnement $wp_j$ sont invalidées, la valeur de ces paramètres est alors déterminée en fonction $wp_j$ de la dernière valeur connue desdits paramètres. Par exemple, si le paramètre de fonctionnement invalidé concerne l'état de charge noté $SOC_i$, alors la valeur de l'état de charge pourra être déterminée à l'aide de la formule suivante :

[Math 1]

$$SOC_i = SOC_{i-1} + \int_{i-1}^{i} I dt$$

où $i$ est l'intervalle pour lequel la valeur de l'état de charge déterminée à l'aide des corrélations a été invalidée, $I$ est le courant traversant le système électrochimique SE entre l'instant $i$ - 1 et l'instant $i$ et $SOC_{i-1}$ est la dernière valeur connue de l'état de charge, $i$ - 1 étant l'instant associé à cette dernière valeur connue.

Dans un mode de réalisation, lorsque la valeur d'un ou de plusieurs paramètres invalidée est déterminée en fonction de la dernière valeur connue desdits paramètres, les corrélations déterminées lors de la phase PA d'apprentissage sont réévaluées en prenant en compte la valeur ainsi déterminée. Ainsi, il est possible de corriger les corrélations déterminées lors de la phase PA d'apprentissage avec ces nouvelles valeurs et ainsi améliorer les déterminations futures du ou des paramètres de fonctionnement $wp_j$ concernés. Le procédé 200 selon un deuxième aspect de l'invention permet ainsi de faire évoluer l'apprentissage au cours du fonctionnement du système électrochimique SE. Ainsi, grâce à l'ajout progressif de nouveaux points permettant d'établir de nouvelles corrélations, le procédé 200 selon un deuxième aspect de l'invention peut s'adapter à des évolutions lentes du système électrochimique SE. Il peut notamment s'adapter aux évolutions liées au vieillissement du système SE.

Dans un mode de réalisation, les corrélations sont déterminées à partir de l'ensemble des réponses RE du système électrochimique SE enregistrées lors de la phase PA d'apprentissage et enregistrées lorsque la valeur d'un ou plusieurs paramètres de fonctionnement $wp_j$ a été invalidée. Il est alors possible de calculer le nombre de données qui ont été ajoutées pour un intervalle de temps donné suite à l'invalidation d'une ou plusieurs valeurs d'un ou plusieurs paramètres de fonctionnement $wp_j$. Une accélération de ce nombre par unité de temps peut être un signe de vieillissement rapide de la batterie.

Dans un mode de réalisation alternatif, les corrélations sont déterminées à partir des réponses RE du système électrochimique SE enregistrées lors de la phase PA d'apprentissage et enregistrées lorsque la valeur d'un ou plusieurs paramètres de fonctionnement $wp_j$ a été invalidée dont l'âge (c'est-à-dire la différence entre l'instant considéré et l'instant auquel a eu lieu l'enregistrement) est inférieur à un âge prédéterminé. Cela permet notamment de limiter la taille de la mémoire allouée à l'enregistrement des réponses RE. Là encore, le nombre de données « oubliées » par unité de temps peut être révélateur du vieillissement du système électrochimique SE.

Dans un mode de réalisation, les étapes de la phase PC de caractérisation sont répétées à intervalles réguliers. De plus, lorsque durant un nombre d'itérations successives supérieur ou égal à un seuil prédéterminé, la détermination est invalidée, la phase de caractérisation comprend une étape 2C5 de détection d'un défaut de fonctionnement du système électrochimique SE. Ainsi, une invalidation répétée des valeurs déterminées à l'aide des corrélations sera considérée comme étant due à un défaut dans le système électrochimique SE.

Dans un mode de réalisation, les étapes de la phase PC de caractérisation sont répétées à intervalles réguliers. De plus, lorsque la valeur d'un ou plusieurs paramètres de fonctionnement $wp_j$ est invalidée, alors l'intervalle séparant les différentes itérations est réduit. Une telle réduction de l'intervalle permet généralement de retrouver une valeur correcte du ou des paramètres concernés.

Dans un mode de réalisation, lors de la phase PC de caractérisation, lorsque les valeurs du ou des paramètres de fonctionnement sont invalidées, le procédé comprend une étape d'affichage et/ou d'envoi d'un message avertissant l'utilisateur que la valeur du ou des paramètres de fonctionnement est erronée. Un tel message peut être associé à l'envoie d'un message instruisant au dispositif de gestion du système électrochimique SE de passer en mode dégradé.

Dispositif associé aux procédés selon un premier ou un deuxième aspect de l'invention

Un troisième aspect de l'invention concerne un dispositif comprenant les moyens configurés pour mettre en oeuvre un procédé selon un premier 100 ou un deuxième 200 aspect de l'invention. Dans un mode de réalisation, le dispositif comprend des moyens PZ1 pour générer un signal d'identification SI ou un signal sonde SS au sein d'un système électrochimique SE. Dans un mode de réalisation, ces moyens de génération peuvent être disposés de manière amovible sur le système électrochimique SE. Dans un mode de réalisation, le dispositif comprend des moyens PZ2 pour réceptionner la réponse RE du système électrochimique SE au signal d'identification SI ou au signal sonde SS. Dans un mode de réalisation, ces moyens de réception peuvent être disposés de manière amovible sur le système électrochimique SE. Dans un mode de réalisation, le dispositif comprend un moyen de calcul (par exemple un processeur) et une mémoire (par exemple une mémoire vive et/ou un disque dur), la mémoire étant configurée pour stocker les instructions nécessaires pour la mise en oeuvre d'un procédé selon un premier 100 ou un deuxième 200 aspect de l'invention. Par ailleurs, le moyen de calcul est configuré pour accéder à cette mémoire est exécuter les instructions. Le moyen de calcul est configuré pour commander les moyens PZ1 de génération du signal sonde SS ou du signal d'identification SI et pour réceptionner les données collectées par le moyen de réception PZ2 de la réponse RE du système électrochimique SE. Dans un mode de réalisation, le dispositif est un système de gestion de système électrochimique SE, par exemple un système de gestion d'une batterie.

**Revendications**

1. Procédé (100) de détermination d'un signal sonde (SS) pour la caractérisation acoustique d'un système électrochimique (SE), la détermination du signal sonde (SS) se faisant à l'aide d'un signal d'identification (SI) émis dans un système électrochimique (SE) de référence de sorte à induire une réponse (RE) du système électrochimique (SE) de référence, le procédé comprenant, pour une pluralité de points de fonctionnement {$PF_i$} du système électrochimique (SE) de référence, chaque point de fonctionnement $PF_i$ étant défini par au moins un paramètre de fonctionnement $wp_j^i$ du système électrochimique (SE) de référence :

    - une étape (1E1) d'émission du signal d'identification (SI), le signal d'identification (SI) étant composé d'une pluralité de fréquences sur une bande passante prédéterminée et étant choisi de sorte à établir un régime stationnaire au sein du système électrochimique (SE) de référence et à induire une réponse linéaire au sein du système électrochimique (SE) de référence ;
    - une étape (1E2) de mesure de la réponse (RE) du système électrochimique (SE) de référence au signal d'identification (SI) ;

de sorte à obtenir une pluralité de réponse (RE) du système électrochimique (SE) de référence, chaque réponse (RE) étant associée à un point de fonctionnement donnée $PF_i$ ; le procédé comprenant en outre :

- une étape (1E3) de détermination des corrélations entre le ou les paramètres de fonctionnement $wp_j^i$ définissant le point de fonctionnement $PF_i$ considéré et au moins une caractéristique de la réponse (RE) du système électrochimique (SE) de référence ;
- une étape (1E4) de détermination d'un signal sonde (SS) à partir de la ou des caractéristiques $wp_i$ présentant une corrélation avec le ou les paramètres de fonctionnement $wp_i$ au-dessus d'une valeur seuil prédéterminée.

**2.** Procédé (100) selon la revendication précédente dans lequel la réponse (RE) du système électrochimique est associée à au moins une caractéristique temporelle $ct_i$ et/ou à au moins une caractéristique fréquentielle $cf_i$.

**3.** Procédé (100) selon l'une des revendications précédentes dans lequel la variation de la ou des caractéristiques de la réponse (RE) du système électrochimique (SE) entre deux valeurs extrêmes du paramètre de fonctionnement $wp_i$ ou d'au moins un paramètre de fonctionnement $wp_i$ parmi les paramètres de fonctionnement $wp_i$ est également prise en compte lors de l'étape (1E4) de détermination d'un signal sonde (SS).

**4.** Procédé (200) de caractérisation acoustique d'un système électrochimique (SE) au moyen d'un signal sonde (SS) obtenue à l'aide d'un procédé (100) selon l'une des revendications précédentes, le procédé comprenant une phase (PA) d'apprentissage permettant d'établir des corrélations entre au moins un paramètre de fonctionnement $wp_i$ du système électrochimique (SE) et au moins deux caractéristiques de la réponse (RE) du système électrochimique (SE) au signal sonde (SS) choisies parmi au moins une caractéristique temporelle $ct_i$ et/ou au moins une caractéristique fréquentielle $cf_i$ ; et une phase (PC) de caractérisation de l'état du système électrochimique comprenant :

- une étape (2C1) d'émission du signal sonde (SS) dans le système électrochimique (SE) de sorte à induire une réponse (RE) dans le système électrochimique (SE) ;
- une étape (2C2) d'enregistrement de la réponse (RE) du système électrochimique (SE) au signal sonde (SS), l'enregistrement concernant les caractéristiques de la réponse (RE) choisies ;
- une étape (2C3) de détermination du ou des paramètres de fonctionnement $wp_i$ à partir des caractéristiques de la réponse (RE) enregistrées lors de l'étape (2C2) d'enregistrement de la réponse (RE) et à partir des corrélations déterminées lors de la phase (PA) d'apprentissage.

**5.** Procédé (200) selon la revendication précédente dans lequel les corrélations établies lors de la phase (PA) d'apprentissage concernent au moins un premier paramètre de fonctionnement $wp_i$ et un deuxième paramètre de fonctionnement, dit paramètre de test $wp_{test}$, lesdits paramètres ayant été pris en compte lors de la détermination du signal sonde (SS), et dans lequel la phase (PC) de caractérisation comprend :

- une étape (2C1') de mesure du paramètre de test $wp_{test}$ cette étape (2C1') de mesure étant concomitante à l'étape (2C1) d'émission du signal sonde (SS) de la phase de caractérisation ;
- après l'étape (2C3) de détermination du ou des paramètres de fonctionnement $wp_i$, une étape (2C4) d'évaluation de la précision de la détermination en fonction de la valeur mesurée du paramètre de test $wp_{test}$ et la valeur déterminée à l'aide des corrélations de ce même paramètre.

**6.** Procédé (200) selon la revendication précédente dans lequel, lors de la phase (PC) de caractérisation, lors que la précision évaluée lors de l'étape (2C4) d'évaluation de la précision est en-dessous d'un seuil prédéterminé, la valeur du ou des paramètres déterminés à l'aide des corrélations est invalidée.

**7.** Procédé (200) selon la revendication précédente dans lequel, lors de la phase (PC) de caractérisation, lorsque la valeur des paramètres de fonctionnement $wp_i$ est invalidée, la valeur de ces paramètres de fonctionnement $wp_i$ est alors déterminée en fonction de la dernière valeur connue desdits paramètres.

**8.** Procédé (200) selon l'une des deux revendications précédentes dans lequel les étapes (2C1-2C4) de la phase (PC) de caractérisation sont répétées à intervalles réguliers et dans lequel, lorsque durant un nombre d'itérations successives supérieur ou égal à un seuil prédéterminé, la valeur du ou des paramètre de fonctionnement $wp_i$ déterminée à l'aide des corrélations est invalidée, la phase (PC) de caractérisation comprend une étape (2C5) de détection d'un défaut de fonctionnement du système électrochimique (SE).

**9.** Procédé (200) selon l'une des cinq revendications précédentes dans lequel la phase (PA) d'apprentissage comporte, pour au moins un système électrochimique (SE) étalon et pour chaque point de fonctionnement $PF_i$ d'une pluralité

de point de fonctionnement $\{PF_i\}$ :

- une étape (2A1) d'émission du signal sonde (SS) de sorte à induire une réponse (RE) dans le système électrochimique (SE) ;
- une étape (2A2) de mesure du ou des paramètres de fonctionnement $wp_i$ du système électrochimique (SE) étalon relatif au point de fonctionnement $CF_i$, cette étape de mesure étant concomitante à l'étape d'émission du signal sonde (SS) ;
- une étape (2A3) d'enregistrement de la réponse (RE) du système électrochimique (SE) au signal sonde (SS), l'enregistrement concernant au moins deux caractéristiques de la réponse (RE) choisies parmi au moins une caractéristique temporelle $ct_i$ et/ou au moins une caractéristique fréquentielle $cf_i$ ;

de sorte à obtenir une pluralité d'enregistrement de la réponse (RE) ; la phase (PA) d'apprentissage comprenant en outre une étape (2A4) de détermination des corrélations entre le ou les paramètres de fonctionnement $wp_i$ mesurés et les caractéristiques de la réponse (RE) choisies.

10. Procédé (200) selon la revendication précédente **caractérisé en ce que**, lors de l'étape (2A4) de détermination des corrélations, chaque paramètre de fonctionnement $wp_i$ est pondéré.

11. Procédé (200) selon l'une des deux revendications précédentes **caractérisé en ce qu'**une pluralité de paramètre de fonctionnement $\{wp_i\}$ est mesurée lors de l'étape (2A2) de mesure du ou des paramètres de fonctionnement $wp_i$ et **en ce que**, lors de l'étape (2A4) de détermination des corrélations, la détermination des corrélations pour un paramètre de fonctionnement donné $wp_i$ prend en compte les autres paramètres de fonctionnement $wp_j$.

12. Procédé de gestion d'un système électrochimique mettant en oeuvre un procédé selon l'une des revendications précédentes.

13. Dispositif comprenant les moyens configurés pour mettre en oeuvre un procédé selon l'une des revendications précédentes.

14. Programme d'ordinateur comprenant des instructions qui conduisent un dispositif selon la revendication précédente à mettre en oeuvre le procédé selon l'une des revendications 1 à 12.

15. Support de données lisible par ordinateur, sur lequel est enregistré le programme d'ordinateur selon la revendication précédente.

**Patentansprüche**

1. Verfahren (100) zur Bestimmung eines Sondensignals (SS) zur akustischen Charakterisierung eines elektrochemischen Systems (SE), wobei die Bestimmung des Sondensignals (SS) mithilfe eines Identifikationssignals (SI) erfolgt, das in einem elektrochemischen Referenzsystem (SE) ausgesendet wird, so dass eine Antwort (RE) des elektrochemischen Referenzsystems (SE) induziert wird, wobei das Verfahren für eine Vielzahl von Betriebspunkten $\{PF_i\}$ des elektrochemischen Referenzsystems (SE) die nachfolgenden Schritte umfasst, und wobei jeder Betriebspunkt $PF_i$ durch mindestens einen Betriebsparameter $wp^i_j$ des elektrochemischen Referenzsystems (SE) definiert ist:

- einen Schritt (1E1) des Sendens des Identifikationssignals (SI), wobei das Identifikationssignal (SI) aus einer Vielzahl von Frequenzen auf einer vorbestimmten Bandbreite zusammengesetzt ist und so gewählt ist, dass es einen stationären Zustand innerhalb des elektrochemischen Referenzsystems (SE) herstellt und eine lineare Antwort innerhalb des elektrochemischen Referenzsystems (SE) induziert;
- einen Schritt (1E2) des Messens der Antwort (RE) des elektrochemischen Referenzsystems (SE) auf das Identifikationssignal (SI);

so dass eine Vielzahl von Antworten (RE) des elektrochemischen Referenzsystems (SE) erhalten wird, wobei jede Antwort (RE) mit einem gegebenen Betriebspunkt $PF_i$ verbunden ist; und wobei das Verfahren ferner umfasst:

- einen Schritt (1E3) des Bestimmens der Korrelationen zwischen dem oder den Betriebsparametern $wpj$, die den betrachteten Betriebspunkt $PF_i$ definieren, und mindestens einem Merkmal der Antwort (RE) des elektrochemischen Referenzsystems (SE);

- einen Schritt (1E4) des Bestimmens eines Sondensignals (SS) aus dem Merkmal oder den Merkmalen $wp_i$, das/die eine Korrelation mit dem Betriebsparameter oder den Betriebsparametern $wp_i$ über einem vorbestimmten Schwellenwert aufweist/aufweisen.

2. Verfahren (100) nach dem vorhergehenden Anspruch, bei dem die Antwort (RE) des elektrochemischen Systems mit mindestens einem Zeitmerkmal $ct_i$ und/oder mindestens einem Frequenzmerkmal $cf$ verknüpft wird.

3. Verfahren (100) nach einem der vorhergehenden Ansprüche, bei dem die Änderung des/der Merkmals(e) der Antwort (RE) des elektrochemischen Systems (SE) zwischen zwei Extremwerten des Betriebsparameters $wp_i$ oder mindestens eines Betriebsparameters $wp_i$ der Betriebsparameter $wp_i$ auch in dem Schritt (1E4) des Bestimmens eines Sondensignals (SS) berücksichtigt wird.

4. Verfahren (200) zur akustischen Charakterisierung eines elektrochemischen Systems (SE) mittels eines Sondensignals (SS), das mithilfe eines Verfahrens (100) nach einem der vorhergehenden Ansprüche erhalten wurde, wobei das Verfahren eine Lernphase (PA) umfasst, die es ermöglicht, Korrelationen zwischen mindestens einem Betriebsparameter $wp_i$ des elektrochemischen Systems (SE) und mindestens zwei Merkmalen der Antwort (RE) des elektrochemischen Systems (SE) auf das Sondensignal (SS) herzustellen, die aus mindestens einem Zeitmerkmal $ct_i$ und/oder mindestens einem Frequenzmerkmal $cf$ ausgewählt werden; und eine Phase (PC) zur Charakterisierung des Zustands des elektrochemischen Systems, die Folgendes umfasst:

   - einen Schritt (2C1) des Sendens des Sondensignals (SS) in das elektrochemische System (SE), um so eine Antwort (RE) in dem elektrochemischen System (SE) zu induzieren;
   - einen Schritt (2C2) des Speicherns der Antwort (RE) des elektrochemischen Systems (SE) auf das Sondensignal (SS), wobei das Speichern die ausgewählten Merkmale der Antwort (RE) betrifft;
   - einen Schritt (2C3) des Bestimmens des oder der Betriebsparameter $wp_i$ aus den Merkmalen der Antwort (RE), die während des Schritts (2C2) des Speicherns der Antwort (RE) gespeichert wurden, und aus den Korrelationen, die während der Lernphase (PA) bestimmt wurden.

5. Verfahren (200) nach dem vorhergehenden Anspruch, bei dem die in der Lernphase (PA) erstellten Korrelationen mindestens einen ersten Betriebsparameter $wp_i$ und einen zweiten Betriebsparameter, den sogenannten Testparameter $wp_{test}$, betreffen, wobei die Parameter bei der Bestimmung des Sondensignals (SS) berücksichtigt wurden, und bei dem die Charakterisierungsphase (PC) umfasst:

   - einen Schritt (2C1') des Messens des Testparameters $wptest$, wobei dieser Schritt (2C1') des Messens mit dem Schritt (2C1) des Sendens des Sondensignals (SS) der Charakterisierungsphase einhergeht;
   - nach dem Schritt (2C3) des Bestimmens des Betriebsparameters oder der Betriebsparameter $wp_i$ einen Schritt (2C4) des Beurteilens der Genauigkeit der Bestimmung in Abhängigkeit von dem gemessenen Wert des Testparameters $wp_{test}$ und dem mithilfe der Korrelationen desselben Parameters bestimmten Wert.

6. Verfahren (200) nach dem vorhergehenden Anspruch, bei dem in der Charakterisierungsphase (PC), wenn die in dem Schritt (2C4) der Bewertung der Genauigkeit bewertete Genauigkeit unter einem vorbestimmten Schwellenwert liegt, der Wert des oder der mithilfe der Korrelationen bestimmten Parameter ungültig gemacht wird.

7. Verfahren (200) nach dem vorhergehenden Anspruch, bei dem in der Charakterisierungsphase (PC), wenn der Wert der Betriebsparameter $wp_j$ ungültig gemacht wird, der Wert dieser Betriebsparameter $wp_j$ dann in Abhängigkeit von dem letzten bekannten Wert dieser Parameter bestimmt wird.

8. Verfahren (200) nach einem der beiden vorhergehenden Ansprüche, bei dem die Schritte (2C1-2C4) der Charakterisierungsphase (PC) in regelmäßigen Abständen wiederholt werden und bei dem, wenn während einer Anzahl aufeinanderfolgender Wiederholungen, die größer oder gleich einem vorbestimmten Schwellenwert ist, der Wert des oder der mithilfe der Korrelationen bestimmten Betriebsparameter $wp_j$ ungültig wird, die Charakterisierungsphase (PC) einen Schritt (2C5) zur Erfassung eines Betriebsfehlers des elektrochemischen Systems (SE) umfasst.

9. Verfahren (200) nach einem der fünf vorhergehenden Ansprüche, bei dem die Lernphase (PA) für mindestens ein elektrochemisches Standardsystem (SE) und für jeden Betriebspunkt $PF_i$ aus einer Vielzahl von Betriebspunkten $\{PF_i\}$ umfasst:

   - einen Schritt (2A1) des Sendens des Sondensignals (SS), um so eine Antwort (RE) in dem elektrochemischen System (SE) zu induzieren;
- einen Schritt (2A2) des Messens des Betriebsparameters oder der Betriebsparameter $wp_i$ des elektrochemischen Standardsystems (SE) bezüglich des Betriebspunkts $CF_i$, wobei dieser Messschritt mit dem Schritt des Sendens des Sondensignals (SS) einhergeht;
- einen Schritt (2A3) des Speicherns der Antwort (RE) des elektrochemischen Systems (SE) auf das Sondensignal (SS), wobei das Speichern mindestens zwei Merkmale der Antwort (RE) betrifft, die aus mindestens einem Zeitmerkmal $ct_i$ und/oder mindestens einem Frequenzmerkmal $cf_i$ ausgewählt sind;

so dass eine Vielzahl von Speicherungen der Antwort (RE) erhalten wird; wobei die Lernphase (PA) außerdem einen Schritt (2A4) des Bestimmens von Korrelationen zwischen dem oder den gemessenen Betriebsparametern $wp_i$ und den ausgewählten Merkmalen der Antwort (RE) umfasst.

10. Verfahren (200) nach dem vorhergehenden Anspruch, **dadurch gekennzeichnet, dass** in dem Schritt (2A4) des Bestimmens der Korrelationen jeder Betriebsparameter $wp_i$ gewichtet wird.

11. Verfahren (200) nach einem der beiden vorhergehenden Ansprüche, **dadurch gekennzeichnet, dass** eine Vielzahl von Betriebsparametern $\{wp_j\}$ in dem Schritt (2A2) des Messens des Betriebsparameters oder der Betriebsparameter $wp_i$ gemessen wird und dass in dem Schritt (2A4) des Bestimmens von Korrelationen das Bestimmen von Korrelationen für einen gegebenen Betriebsparameter $wp_i$ die anderen Betriebsparameter $wp_j$ berücksichtigt werden.

12. Verfahren zur Verwaltung eines elektrochemischen Systems, bei dem ein Verfahren nach einem der vorhergehenden Ansprüche angewendet wird.

13. Vorrichtung mit Mitteln, die so konfiguriert sind, dass sie ein Verfahren nach einem der vorhergehenden Ansprüche durchführen.

14. Computerprogramm mit Anweisungen, die eine Vorrichtung nach dem vorhergehenden Anspruch dazu veranlassen, das Verfahren nach einem der Ansprüche 1 bis 12 umzusetzen.

15. Computerlesbarer Datenträger, auf dem das Computerprogramm nach dem vorhergehenden Anspruch gespeichert ist.

**Claims**

1. Method (100) for determining a probe signal (SS) for acoustically characterising an electrochemical system (SE), the probe signal (SS) being determined by means of an identification signal (SI) transmitted in a reference electrochemical system (SE) so as to induce a response (RE) from the reference electrochemical system (SE), the method comprising, for a plurality of operating points $\{PF_i\}$ of the reference electrochemical system (SE), each operating point $PF_i$ being defined by at least one operating parameter $wp_j^i$ of the reference electrochemical system (SE):

   - a step (1E1) of transmitting the identification signal (SI), the identification signal (SI) being composed of a plurality of frequencies over a predetermined bandwidth and being chosen so as to establish a steady state within the reference electrochemical system (SE) and induce a linear response within the reference electrochemical system (SE);
   - a step (1E2) of measuring the response (RE) of the reference electrochemical system (SE) to the identification signal (SI);

   in such a way as to obtain a plurality of responses (RE) of the reference electrochemical system (SE), each response (RE) being associated with a given operating point $PF_i$; the method further comprising:

   - a step (1E3) of determining correlations between the operating parameter or parameters $wp_j^i$ defining the considered operating point $PF_i$ and at least one feature of the response (RE) of the reference electrochemical system (SE);
   - a step (1E4) of determining a probe signal (SS) from the feature or features $wp_i$ having a correlation with the operating parameter or parameters $wp_i$ above a predetermined threshold value.

2. Method (100) according to the preceding claim wherein the response (RE) of the electrochemical system is associated with at least one time feature $ct_i$ and/or with at least one frequency feature $cf_i$.

3. Method (100) according to one of the preceding claims wherein the variation in the feature or features of the response (RE) of the electrochemical system (SE) between two extreme values of the operating parameter $wp_i$ or of at least one operating parameter $wp_i$ among the operating parameters $wp_i$ is also taken into account during the step (1E4) of determining a probe signal (SS).

4. Method (200) for acoustically characterising an electrochemical system (SE) by means of a probe signal (SS) obtained using a method (100) according to one of the preceding claims, the method comprising a learning phase (PA) making it possible to establish correlations between at least one operating parameter $wp_i$ of the electrochemical system (SE) and at least two features of the response (RE) of the electrochemical system (SE) to the probe signal (SS) chosen from at least one time feature $ct_i$ and/or at least one frequency feature $cf_i$; and a characterisation phase (PC) of the state of the electrochemical system comprising:

   - a step (2C1) of transmitting the probe signal (SS) in the electrochemical system (SE) in such a way as to induce a response (RE) in the electrochemical system (SE);
   - a step (2C2) of recording the response (RE) of the electrochemical system (SE) to the probe signal (SS), the recording concerning the chosen features of the response (RE);
   - a step (2C3) of determining the operating parameter or parameters $wp_i$ from features of the response (RE) recorded during the step (2C2) of recording the response (RE) and from correlations determined during the learning phase (PA).

5. Method (200) according to the preceding claim wherein the correlations established during the learning phase (PA) concern at least one first operating parameter $wp_i$ and a second operating parameter, referred to as test parameter $wp_{test}$, said parameters having been taken into account during the determining of the probe signal (SS), and wherein the characterisation phase (PC) comprises:

   - a step (2C1') of measuring the test parameter $wp_{test}$, this step (2C1') of measuring being concurrent with the step (2C1) of transmitting the probe signal (SS) of the characterisation phase;
   - after the step (2C3) of determining the operating parameter or parameters $wp_i$, a step (2C4) of evaluating the precision of the determining according to the measured value of the test parameter $wp_{test}$ and the value determined using correlations of this same parameter.

6. Method (200) according to the preceding claim wherein, during the characterisation phase (PC), when the precision evaluated during the step (2C4) of evaluating the precision is below a predetermined threshold, the value of the parameter or parameters determined using correlations is invalidated.

7. Method (200) according to the preceding claim wherein, during the characterisation phase (PC), when the value of the operating parameters $wp_i$ is invalidated, the value of these operating parameters $wp_i$ is then determined according to the last known value of said parameters.

8. Method (200) according to one of the two preceding claims wherein the steps (2C1-2C4) of the characterisation phase (PC) are repeated at regular intervals and wherein, when during a number of successive iterations greater than or equal to a predetermined threshold, the value of the operating parameter or parameters $wp_i$ determined using correlations is invalidated, the characterisation phase (PC) comprises a step (2C5) of detecting an operating fault of the electrochemical system (SE).

9. Method (200) according to one of the five preceding claims wherein the learning phase (PA) comprises, for at least one standard electrochemical system (SE) and for each operating point $PF_i$ of a plurality of operating points $\{PF_i\}$:

   - a step (2A1) of transmitting the probe signal (SS) in such a way as to induce a response (RE) in the electrochemical system (SE);
   - a step (2A2) of measuring the operating parameter or parameters $wp_i$ of the standard electrochemical system (SE) relative to the operating point $CF_i$, this step of measuring being concurrent with the step of transmitting the probe signal (SS);
   - a step (2A3) of recording the response (RE) of the electrochemical system (SE) to the probe signal (SS), the recording concerning at least two features of the response (RE) chosen from at least one time feature $ct_i$ and/or

at least one frequency feature $cf_i$;

in such a way as to obtain a plurality of recordings of the response (RE); the learning phase (PA) further comprising a step (2A4) of determining correlations between the operating parameter or parameters $wp_i$ measured and the chosen features of the response (RE).

10. Method (200) according to the preceding claim **characterised in that**, during the step (2A4) of determining correlations, each operating parameter $wp_i$ is weighted.

11. Method (200) according to one of the two preceding claims **characterised in that** a plurality of operating parameters $\{wp_i\}$ is measured during the step (2A2) of measuring the operating parameter or parameters $wp_i$ and **in that**, during the step (2A4) of determining correlations, the determining of correlations for a given operating parameter $wp_i$ takes into account the other operating parameters $wp_j$.

12. Method for managing an electrochemical system implementing a method according to one of the preceding claims.

13. Device comprising means configured to implement a method according to one of the preceding claims.

14. Computer program comprising instructions that lead a device according to the preceding claim to implement the method according to one of the preceding claims 1 to 12.

15. A computer-readable storage medium on which is recorded the computer program according to the preceding claim.

[Fig. 1]

100

```
┌─────────────┐
│     1E1     │
└─────────────┘
       │
       ▼
┌─────────────┐
│     1E2     │
└─────────────┘
```

Mesure d'une
pluralité de réponses

```
┌─────────────┐
│     1E3     │
└─────────────┘
       │
       ▼
┌─────────────┐
│     1E4     │
└─────────────┘
```

Détermination du
signal sonde à partir
des corrélations
issues des mesures

[Fig. 2]

SI          RE

SE

PZ1          PZ2

[Fig. 3]

**Evolution au cours du cyclage charge-décharge**

Maximum ----- Minimum

[Fig. 4]

**Evolution au cours du cyclage charge-décharge**

[Fig. 5]

Evolution au cours du cyclage charge-décharge

[Fig. 6]

200

PA

Etablissement des
corrélations entre les
caractéristiques de la répons
et le point de fonctionnemen
du système

PC

2C1

2C2

2C3

Utilisation des corrélations
déterminées précédemment
pour la détermination du poir
de fonctionnement du
système

[Fig. 7]

SS

RE

SE

PZ1

PZ2

[Fig. 8]

[Fig. 9]

[Fig. 10]

[Fig. 11]

[Fig. 12]

## RÉFÉRENCES CITÉES DANS LA DESCRIPTION

**Documents brevets cités dans la description**

- DE 102015210266 A1
- US 20180120168 A1
- US 20180120261 A1
- US 1132781 B2
- US 20160197382 A1
- FR 3080458 A1
- US 2013091950 A1
- WO 2018090678 A1